Europäisches Patentamt

European Patent Office

Office européen des brevets

(19)

(11) **EP 1 475 887 A2**

(12) **EUROPEAN PATENT APPLICATION**

(43) Date of publication:
**10.11.2004 Bulletin 2004/46**

(51) Int Cl.⁷: **H03F 3/60**

(21) Application number: **04010568.6**

(22) Date of filing: **04.05.2004**

| (84) Designated Contracting States:<br>**AT BE BG CH CY CZ DE DK EE ES FI FR GB GR HU IE IT LI LU MC NL PL PT RO SE SI SK TR**<br>Designated Extension States:<br>**AL HR LT LV MK** | (71) Applicant: **NEC CORPORATION**<br>**Tokyo (JP)** |
|---|---|
| (30) Priority: **08.05.2003 JP 2003130229** | (72) Inventor: **Doi, Yoshiaki c/o NEC Corporation**<br>**Minato-ku Tokyo (JP)**<br><br>(74) Representative: **VOSSIUS & PARTNER**<br>**Siebertstrasse 4**<br>**81675 München (DE)** |

(54) **Multiport amplifying apparatus using digital quadrature baseband hybrid circuit for each hybrid in input hybrid network**

(57)     A multiport amplifying apparatus according to the present invention implements each of individual hybrids, which make up an input hybrid network, with a digital quadrature baseband 90-degree hybrid circuit, and can therefore eliminate a gain deviation and phase deviation among lines in the input hybrid network. Consequently, gain deviation and phase deviation values among the lines, required to the overall apparatus, can be distributed only to amplifiers and an output RF-band hybrid network, thus facilitating optimal designing. Further, the input hybrid network can be largely reduced in size and cost because it processes signals in a digital quadrature baseband signal domain.

Fig. 6

EP 1 475 887 A2

## Description

The present invention relates to a multiport amplifying apparatus for use in a multibeam communication satellite, a mobile communication base station using an array antenna, and the like.

A multiport amplifying apparatus is utilized in a multibeam communication satellite and a mobile communication base station using an array antenna. The multiport amplifying apparatus comprises an input hybrid network, an output hybrid network, and amplifiers which connect the input hybrid network to the output hybrid network. The input hybrid network has $2^n$ (n is a natural number) input/output ports, and the output ports are connected to $2^n$ amplifiers. The outputs of the respective amplifiers are connected to the output hybrid network equivalent to the input hybrid network.

The input hybrid network operates to evenly distribute input signals from the $2^n$ input ports to the respective amplifiers. Each of the amplifiers amplifies an input signal evenly distributed thereto. The input signals amplified by the amplifiers are combined in the output hybrid network. The respective combined signals correspond to the input signals applied from the respective input ports. Since the respective amplifiers amplify all input signals from the input ports evenly distributed thereto, the output power levels of the respective amplifiers can be made uniform even if there are level differences among signals at the respective input ports. In other words, each of the amplifiers can be connected to signals at arbitrary input ports for distributed amplification, rather than connecting each signal at an input port to a fixed amplifier, thereby effectively utilizing the amplification dynamic range of each amplifier.

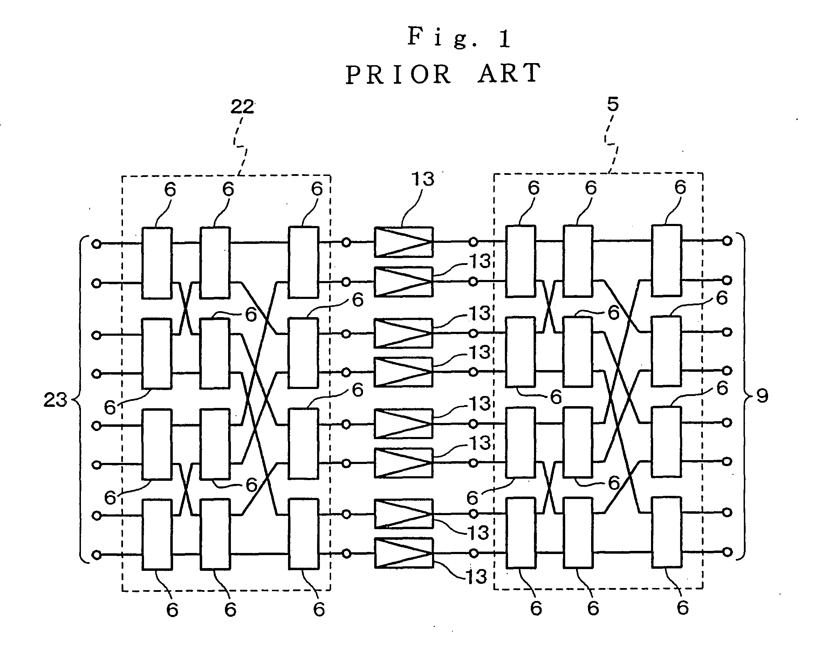

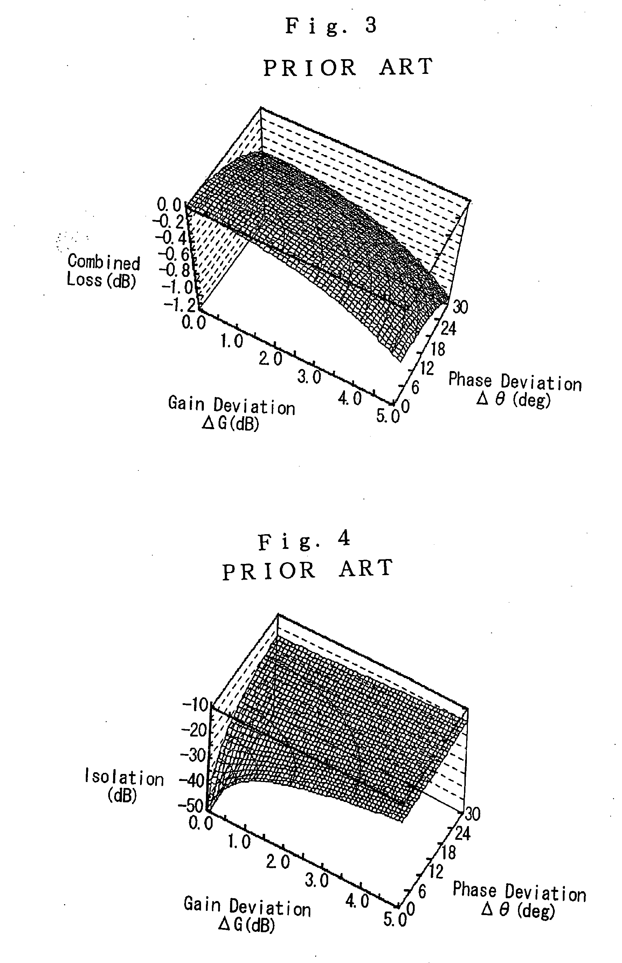

Fig. 1 illustrates an exemplary configuration of an eight-line multiport amplifying apparatus according to the prior art. The eight-line multiport amplifying apparatus comprises input RF-band hybrid network 22, analog RF input type amplifiers 13, and output RF-band hybrid network 5, and has eight RF-band input ports 23 and eight RF-band output ports 9 (see, for example, Fig. 3 in JP-2003-17927-A, Fig. 3 in JP-9-167930-A, and the like).

Input RF-band hybrid network 22 is comprised of RF-band 90-degree hybrids 6 for power distribution. Similarly, output RF-band hybrid network 5 is comprised of RF-band 90-degree hybrids 6 for power combination. Here, the prior art is characterized in that it is RF-band signals that are both distributed and combined in the respective input and output hybrid networks.

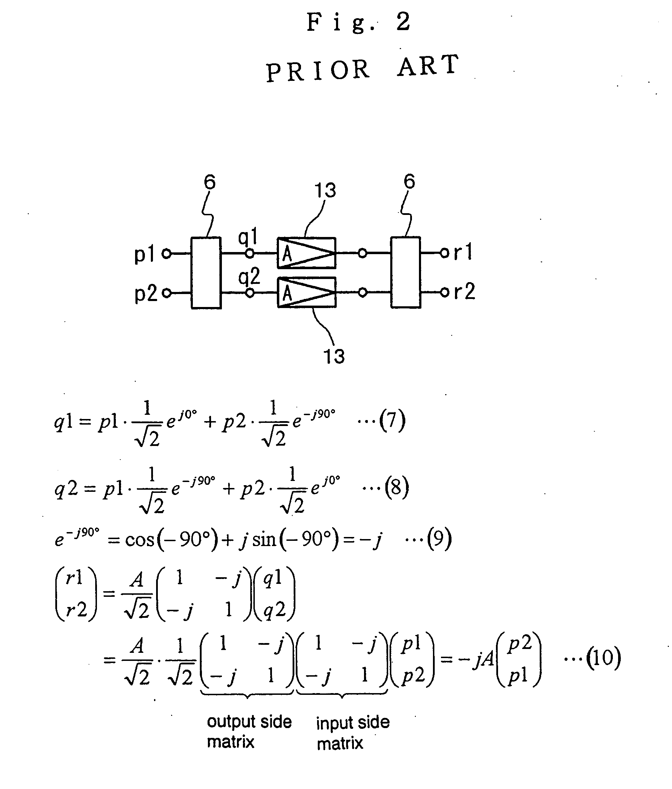

The multiport amplifying apparatus will be described in terms of the operation of the hybrid networks. Fig. 2 illustrates a block diagram for describing the operation of RF-band 90-degree hybrids 6. Illustrated herein is an exemplary two-line multiport amplifying apparatus for simplifying the description. RF-band 90-degree hybrid 6 multiplies the amplitude of each of two RF input signals by $1/\sqrt{2}$, divides each of the resulting signals into a signal at a phase of zero degree and a signal at a phase delayed by 90 degrees, adds the respective signals, and delivers the signals on two lines. The outputs of RF-band 90-degree hybrid 6 are applied to analog RF input type amplifiers 13, respectively. The two RF-band signals amplified by respective analog RF input type amplifiers 13 are changed in amplitude and phase and combined by output RF-band 90-degree hybrid 6, and then delivered therefrom.

In Fig. 2, when the two RF input signals are designated by p1, p2, and two output signals from input RF-band 90-degree hybrid 6 are designated by q1, q2, the input/output relationship of input RF-band 90-degree hybrid 6 can be expressed by Equations (7) and (8). The characteristics of input RF-band 90-degree hybrid 6 are the same as those of the output RF-band 90-degree hybrid 6. When two output signals from output RF-band 90-degree hybrid 6 are designated by r1, r2, and a 90-degree phase delay is represented in matrix using a replacement with Equation (9), the input/output characteristic of the two-line multiport amplifying apparatus is expressed by Equation (10). It should be noted herein that the upper and lower lines in Fig. 2 are inverted at the input ports and output ports.

The conventional multiport amplifying apparatus includes hybrid networks as described above which rely on analog RF-band signals. In such a configuration, a gain deviation and a phase deviation can arise among lines in the multiport amplifying apparatus depending on the characteristics of input RF-band hybrid network 22, each analog RF input type amplifier 13, and output RF-band hybrid network 5 in Fig. 1. The deviations among the lines would significantly affect a combination loss at the outputs and an inter-line isolation. A characteristic analysis on the influence is shown in literature by S. Egami, M. Kawai, entitled "An Adaptive Multiple Beam System Concept," IEEE Journal on Selected Areas in Communications, Vol. SAC-5, No. 4, May, 1987.

For example, the result of an analysis on the characteristics of an eight-line multiport amplifying apparatus may be as shown in Figs. 3 and 4. When a gain standard deviation among respective lines is represented by $\Delta G$ (dB); and a phase standard deviation by $\Delta \theta$ (deg), the influence of the gain standard deviation and phase standard deviation on a combination loss (dB) at the output may be represented by a graph as illustrated in Fig. 3. The graph is drawn on the assumption that for the standard deviation values of the eight lines are evenly distributed over a range of $\pm \Delta G$ (dB) centered at a gain standard value and over a range of $\pm \Delta \theta$ (deg) centered at a phase standard value. The combination loss refers to a loss caused by the influence of the standard deviation except for a fixed insertion loss by the hybrid networks. The influence of the gain standard deviation and phase standard deviation on the inter-line isolation (dB) may be represented by a graph as illustrated in Fig. 4.

For limiting the combination loss to 0.1 dB or less, the gain standard deviation must be reduced to 1.5 dB or less, and the phase standard deviation must be reduced to 10 degrees or less, as can be appreciated from Fig. 3. Further, for ensuring the inter-line isolation of 30 dB or more, the gain standard deviation must be reduced to 0.8 dB or less, and the phase standard deviation must be reduced to 5 deg or less, as can be appreciated from Fig. 4. If the respective required values for the deviations are distributed over the components of input RF-band hybrid network 22, analog RF input type amplifiers 13, and output RF-band hybrid network 5, quite strict characteristics are required for each component.

In input RF-band hybrid network 22 and output RF-band hybrid network 5 as illustrated in Fig. 1, it is difficult to completely match by design the electrical lengths of cables or microstrip lines or strip lines for interconnecting a plurality of RF-band 90-degree hybrids 6 which make up the hybrid networks. This is disadvantageous in that adjustments are required for each apparatus. Further, since the longest electrical length is based on adjusting the remaining lines, the hybrid network increases in size.

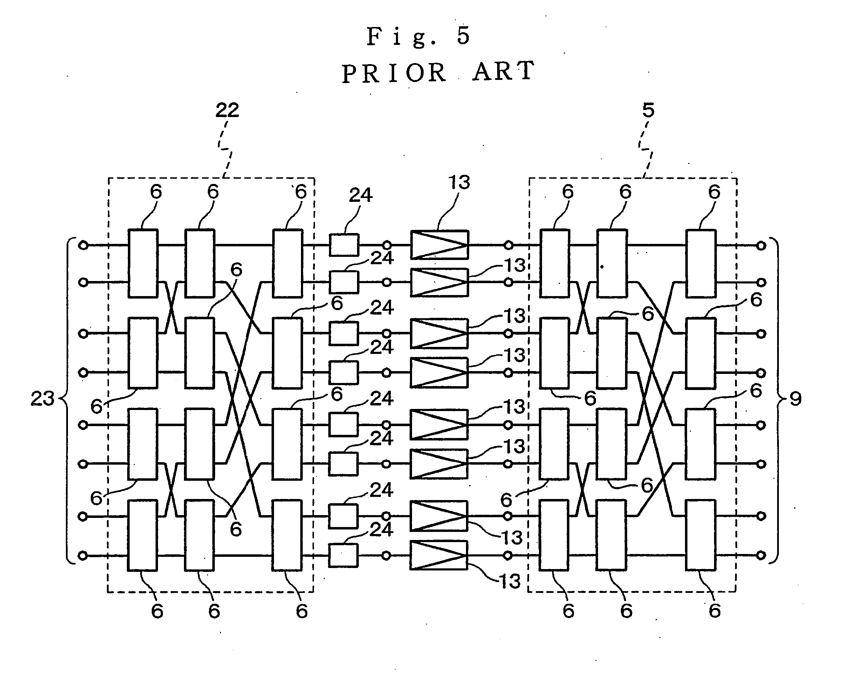

For adjusting each deviation between the lines, a gain phase compensator circuit may be provided in front of each amplifier for compensating the gain and phase. Fig. 5 illustrates RF band gain phase compensator circuits 24 provided between input RF-band hybrid network 22 and respective analog RF input type amplifiers 13 in Fig. 1. With this configuration, the gain deviation and phase deviation among the respective lines can be adjusted at an apparatus level by RF band gain phase compensator circuits 24 which is equal in number to the lines. However, since RF-band gain phase compensator circuits 24 need as many RF-band variable attenuators and variable phase shifters as the number of lines, the resulting apparatus will become expensive. Further, since gain phase compensator circuit 24 is composed of analog elements, the compensation characteristics will experience a frequency deviation, variations due to temperature, and aging changes.

It is an object of the present invention to provide a multiport amplifying apparatus which suppresses deviations among lines, and improves such characteristics as a combination loss, an inter-line isolation, and the like.

It is another object of the present invention to provide a multiport amplifying apparatus which is stable in characteristics with less frequency deviation, temperature induced variations, and aging changes

It is another object of the present invention to facilitate an optimal design for a multiport amplifying apparatus.

It is another object of the present invention to provide a multiport amplifying apparatus for which an adjustment step is reduced for each apparatus to improve the productivity thereof.

It is another object of the present invention to provide a multiport amplifying apparatus which is reduced in size to improve the versatility in installation thereof.

It is another object of the present invention to reduce the cost of the multiport amplifying apparatus.

To achieve the above objects, a multiport amplifying apparatus according to the present invention includes an input hybrid network (1), amplifiers (4, 13), and an output hybrid network (5). The input hybrid network (1) has a plurality of input ports (8). The amplifiers (4, 13) are connected to the output of the input hybrid network (1), and there are the same number of amplifiers as the number of the input ports. The output hybrid network (5) is connected to the outputs of the amplifiers (4, 13), and has a plurality of output ports (9). The input hybrid network (1) receives digital quadrature baseband signals from the plurality of input port (9), and evenly distributes the received digital quadrature baseband signals to a plurality of amplifiers (4, 13).

The input hybrid network (1) in the multiport amplifying apparatus of the present invention includes $2^n$ of the input ports (8) and $2^{(n-1)} \times n$ hybrid circuits (2). The hybrid circuit (2) is a digital hybrid circuit (2) for processing a digital quadrature baseband signal.

The digital hybrid circuit (2) in the multiport amplifying apparatus of the present invention is a digital quadrature baseband hybrid circuit (2) which includes an adder (10) for adding incoming digital quadrature baseband signals, and a subtractor (11) for subtracting one digital quadrature baseband signal from another.

The output hybrid network in the multiport amplifying apparatus of the present invention includes $2^n$ of output ports (9) and $2^{(n-1)} \times n$ output hybrid circuits (6). The output hybrid circuit (6) is an analog hybrid circuit (6) for processing an analog RF-band signal.

Each of the amplifiers (4) in the multiport amplifying apparatus of the present invention is a digital quadrature baseband signal input type amplifier for amplifying a digital quadrature baseband signal received from the input hybrid network and delivering an analog RF-band signal.

The multiport amplifying apparatus of the present invention includes a converter circuit (12) disposed behind the input hybrid network (1) for converting a digital quadrature baseband signal to an analog RF-band signal. The converter circuit (12) includes a digital-to-analog converter (14) for converting the digital quadrature baseband signal to an analog quadrature baseband signal, a filter (15) for filtering out an aliasing component produced by sampling, included in the analog quadrature baseband signal, and a quadrature modulator (16, 16-2) for orthogonally modulating the analog quadrature baseband signal from which the aliasing component has been removed. Each of the amplifiers (13) is an analog RF input type amplifier (13) for amplifying the analog RF-band signal delivered from the converter circuit (12).

The input hybrid network (1) in the multiport amplifying apparatus of the present invention further includes a complex multiplier (18) for adjusting the amplitude and phase of the digital quadrature baseband signal.

The multiport amplifying apparatus of the present invention includes a digital frequency converter (19) disposed in front of the input hybrid network (1).

The multiport amplifying apparatus of the present invention includes a baseband combiner (21) disposed in front of the input hybrid network (1) for combining a plurality of the digital quadrature baseband signals.

With the employment of a digital quadrature baseband hybrid circuit for processing a digital quadrature baseband signal for each of the hybrids which make up the input hybrid network, the multiport amplifying apparatus of the present invention can eliminate a gain deviation and a phase deviation among lines in the input hybrid network.

Consequently, gain deviation and phase deviation values among the lines required to the multiport amplifying apparatus can be distributed to the amplifiers and output hybrid network, thus facilitating optimal designing, as compared with the prior art. Also, since the input hybrid network processes signals in a digital quadrature baseband signal domain, the input hybrid network can be largely reduced in size and cost as compared with the prior art.

With the provision of the complex multiplier for adjusting the amplitude and phase of the digital quadrature baseband signal to meet the gain deviation and phase deviation values among the lines distributed only to the amplifiers and output hybrid network, adjustments can be further simplified to facilitate the optimal designing. Since this complex multiplier processes in a digital quadrature baseband signal domain, the complex multiplier can be largely reduced in size and cost and can improve the stability, as compared with a prior art gain and phase compensator circuit which operates in an analog RF-band.

The above and other objects, features and advantages of the present invention will become apparent from the following description with reference to the accompanying drawings which illustrate examples of the present invention.

Fig. 1 is a block diagram illustrating the basic configuration of an eight-line multiport amplifying apparatus according to the prior art;
Fig. 2 is a block diagram illustrating the configuration of a two-line multiport amplifying apparatus according to the prior art which uses an RF-band 90-degree hybrids;
Fig. 3 is a graph representing the influence of a gain standard deviation and a phase standard deviation among respective lines on a combination loss at the output of the eight-line multiport amplifying apparatus;

Fig. 4 is a graph representing the influence of a gain standard deviation and a phase standard deviation among respective lines on an inter-line isolation of the eight-line multiport amplifying apparatus;
Fig. 5 is a block diagram illustrating the basic configuration of an eight-line multiport amplifying apparatus according to the prior art which comprises RF-band gain phase compensator circuits;
Fig. 6 is a block diagram illustrating an exemplary basic configuration of an eight-line multiport amplifying apparatus according to a first embodiment of the present invention;
Fig. 7 is a block diagram illustrating the basic configuration of a digital quadrature baseband 90-degree hybrid circuit employed in the eight-line multiport amplifying apparatus of Fig. 6;
Fig. 8 is a block diagram illustrating the configuration of a two-line multiport amplifying apparatus which employs the digital quadrature baseband 90-degree hybrid circuit of Fig. 7;
Fig. 9 is a block diagram illustrating the configuration of an exemplary modification to the digital quadrature baseband 90-degree hybrid circuit in the first embodiment;
Fig. 10 is a block diagram illustrating the configuration of a two-line multiport amplifying apparatus which employs the digital quadrature baseband 90-degree hybrid circuit of Fig. 9;
Fig. 11 is a block diagram illustrating an exemplary basic configuration of an eight-line multiport amplifying apparatus according to a second embodiment of the present invention;
Fig. 12 is a block diagram illustrating the basic configuration of a converter circuit in the multiport amplifying apparatus;
Fig. 13 is a block diagram illustrating the basic configuration of an exemplary modification to the converter circuit in the second embodiment;
Fig. 14 is a block diagram illustrating the basic configuration of an eight-line multiport amplifying apparatus according to a third embodiment of the present invention;
Fig. 15 is a block diagram illustrating the configuration of a complex multiplier in the multiport amplifying apparatus;
Fig. 16 is a block diagram illustrating a frequency converter disposed in front of a multiport amplifying apparatus according to a fourth embodiment of the present invention; and
Fig. 17 is a block diagram illustrating a baseband combiner employed in the fourth embodiment.

First embodiment

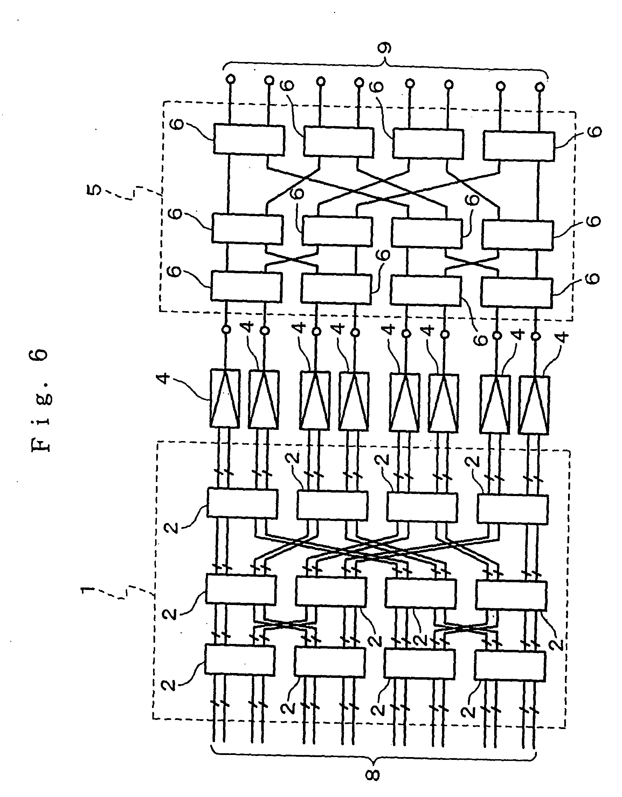

A first embodiment of the present invention will be described with reference to Figs. 6 to 8. Fig. 6 is a block diagram illustrating an exemplary configuration of an eight-line multiport amplifying apparatus. In Fig. 6, components identical to those of the prior art illustrated in Fig. 1 are designated the same reference numerals. The eight-line multiport amplifying apparatus of the first embodiment differs from the prior art counterpart illustrated in Fig. 1 in an input hybrid network and amplifiers. The input hybrid network comprises input digital quadrature baseband hybrid network 1 which includes eight digital quadrature baseband input ports 8 and is made up of digital quadrature baseband 90-degree hybrid circuits 2. The amplifiers connected to the input hybrid network are digital quadrature baseband input amplifiers 4. Digital quadrature baseband input amplifier 4 is represented by a digital predistortion type amplifier. Output hybrid network 5 has the same configuration as the prior art example illustrated in Fig. 1.

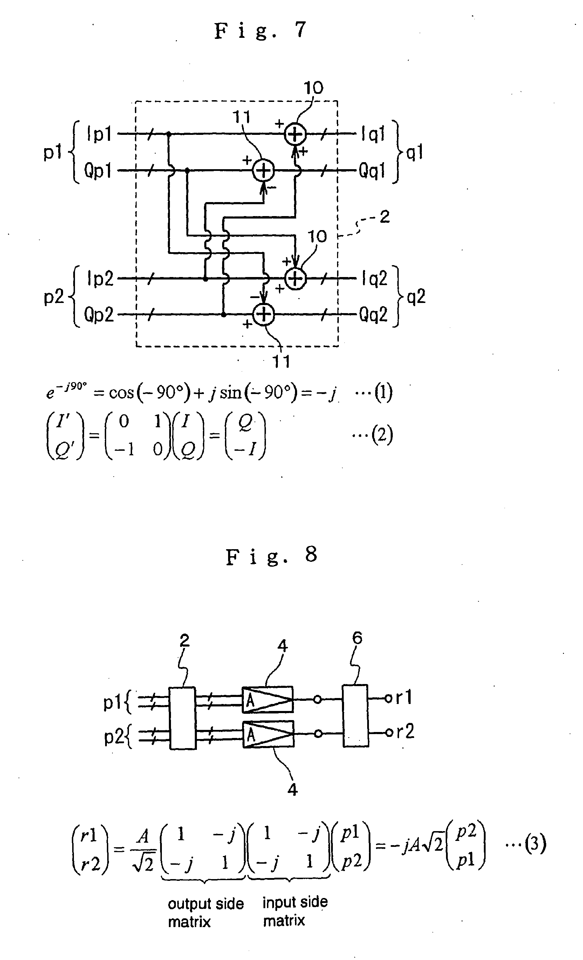

Fig. 7 is a block diagram illustrating the basic configuration of digital quadrature baseband 90-degree hybrid circuit 2. Digital quadrature baseband 90-degree hybrid circuit 2, which comprises two adders 10 and two subtractors 11, receives two digital quadrature baseband input signals p1, p2, and delivers two digital quadrature baseband output signals q1, q2. Digital quadrature baseband input signal p1 is composed of I-component signal Ip1 and Q-component signal Qp1. Digital quadrature baseband input signal p2 is composed of I-component signal Ip2 and Q-component signal Qp2. Also, digital quadrature baseband output signal q1 is composed of I-component signal Iq1 and Q-component signal Qq1, while digital quadrature baseband output signal q2 is composed of I-component signal Ip2 and Q-component signal Qp2.

For two digital quadrature baseband input signals p1, p2, adders 10 and subtractors 11 are connected to satisfy:

$$Iq1 = Ip1 + Qp2$$

$$Qq1 = Qp1 + (-Ip2),$$

and

$$Iq2 = Ip2 + Qp1$$

$$Qq2 = Qp2 + (-Ip1 )$$

Now, the operation of the multiport amplifying apparatus according to the first embodiment of the present invention will be described with reference to the accompanying drawings. Digital quadrature baseband input ports 8 are applied with digital quadrature baseband signals from eight lines. The digital quadrature baseband signals on the eight lines applied to input digital quadrature baseband hybrid network 1 are distributed by respective digital quadrature baseband 90-degree hybrid circuits 2 without any gain deviation or phase deviation among the respective lines. The distributed digital quadrature baseband signals are amplified by associated digital quadrature baseband input amplifiers 4. Since output hybrid network 5 subsequent to digital quadrature baseband input amplifiers 4 is the same as that in the prior art example, description on the operation thereof is omitted.

Next, the operation of digital quadrature baseband 90-degree hybrid circuit 2 will be described with reference to Figs. 7 and 8. Signals on two lines applied to 90-degree hybrid circuit 2 is divided into a signal having an amplitude $1/\sqrt{2}$ times as large and a phase at 0 degree and a signal having an amplitude $1/\sqrt{2}$ times as large and a phase delayed by 90 degrees, which are then added to each other. Here, the phase delay by 90 degrees is expressed by Equation (1) in Fig. 7. In quadrature baseband signals, when input signals are designated by I and Q, and output signals with a phase delay of 90 degrees are designated by I' and Q', I'=Q, Q'=-I are satisfied as expressed by Equation (2). Thus, the relationship between the input and output of digital quadrature baseband 90-degree hybrid circuit 2 is expressed by:

$$Iq1 = Ip1 + Qp2$$

$$Qq1 = Qp1 + (-Ip2),$$

and

$$Iq2 = Ip2 +Qp1$$

$$Qq2 = Qp2 + (-Ip1)$$

where Ip1, Qp1 and Ip2, Qp2 are signal components of two-line digital quadrature baseband input signals p1 and p2, respectively, and Iq1, Qq1 and Iq2, Qq2 are signal components of two-line output signals q1 and q2 of digital baseband 90-degree hybrid circuit 2, respectively.

The foregoing operations may be implemented by an arithmetic circuit composed of two adders 10 and two subtractors 11, as illustrated in Fig. 7. Thus, the arithmetic circuit of Fig. 7 can accomplish characteristics equivalent to those of prior art RF-band 90-degree hybrid 6 and generate two-line digital quadrature baseband output signals without causing a gain deviation or a phase deviation between the respective lines.

Referring next to Fig. 8, description will be made on the operation of a multiport amplifying apparatus which employs digital quadrature baseband 90-degree hybrid circuit 2 illustrated in Fig. 7. Illustrated herein is a two-line multiport amplifying apparatus for simplifying the description. The multiport amplifying apparatus comprises one digital quadrature baseband 90-degree hybrid circuit 2 illustrated in Fig. 7, two digital quadrature baseband input amplifiers 4, and one RF-band 90-degree hybrid 6.

Here, two-line digital quadrature baseband input signals are designated by p1, p2, while two-line output signals of RF-band 90-degree hybrid 6 on the output side are designated by r1, r2. Further, when a 90-degree phase delay is represented in matrix using a replacement with Equation (1), the input/output characteristic of the two-line multiport amplifying apparatus is expressed by Equation (3). This input/output characteristic corresponds to Equation (10) in Fig. 2 associated with the prior art example.

Unlike prior art RF-band 90-degree hybrid 6, digital quadrature baseband 90-degree hybrid circuit 2 on the input side provides the output signals having amplitudes $\sqrt{2}$ times as much as those calculated by Equation (10) because the amplitude of each input signal is not $1/\sqrt{2}$ times (1/2 times when converted to the power). Thus, according to the present invention, assuming that the gain required for the multiport amplifying apparatus is the same as that for the prior art, the gain of the amplifier can be reduced to $1/\sqrt{2}$ times in amplitude (1/2 times in power). It should be apparent that through a similar analysis to the foregoing, the present invention can be applied as well to multiport amplifying apparatuses having any arbitrary number of lines $2^n$ (n is a natural number) including four lines and eight lines.

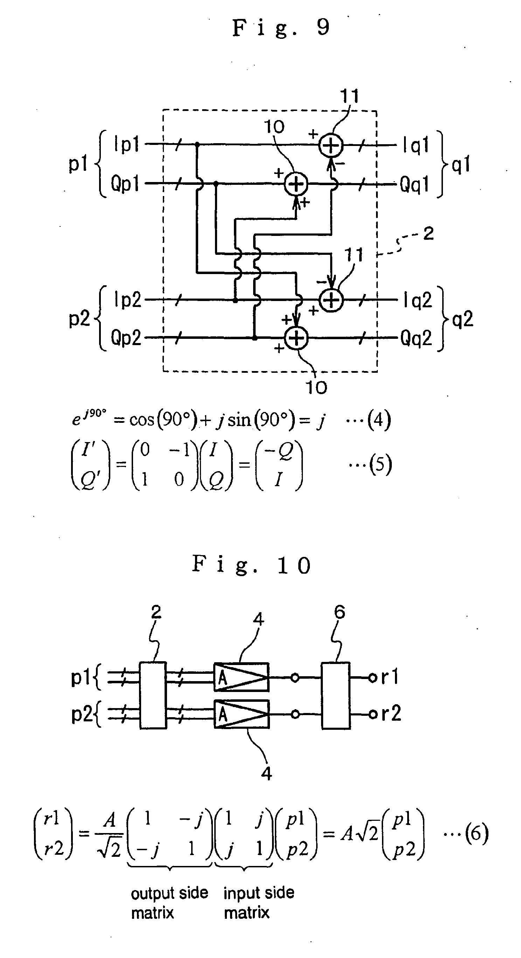

Fig. 9 is a block diagram illustrating the configuration of digital quadrature baseband 90-degree hybrid circuit 2 which is an exemplary modification to the first embodiment of the present invention. This modified hybrid circuit 2 differs from the embodiment of the present invention illustrated in Fig. 7 in that adders 10 are changed in place with subtractors 11 in Fig. 7.

In the following, the operation of digital quadrature baseband 90-degree hybrid circuit 2 will be described with reference to the drawings. In this exemplary modification, unlike the 90-degree phase delay shown in the first embodiment, digital quadrature baseband 90-degree hybrid circuit 2 develops a phase advance of 90 degrees. The 90-degree phase advance is expressed by Equation (4) in Fig. 9. In quadrature baseband signals, when input signals are designated by I and Q, and output signals advanced by 90 degrees in phase are designated by I' and Q', I'=-Q, Q'=I are satisfied, as shown in Equation (5). Therefore, the input/output relationship of digital quadrature baseband 90-degree hybrid circuit 2 are expressed by:

$$Iq1 = Ip1 + (-Qp2)$$

$$Qq1 = Qp1 + Ip2,$$

and

$$iq2 = ip2 + (-Qp1)$$

$$Qq2 = Qp2 + Ip1$$

where Ip1, Qp1 and Ip2, Qp2 are signal components of two-line digital quadrature baseband input signals p1, p2, respectively, and Iq1, Qq1 and Iq2, Qq2 are signal components of two-line output signals q1, q2 of digital quadrature baseband 90-degree hybrid circuit 2.

These operations are likewise implemented by an arithmetic circuit composed of two adders 10 and two subtractors 11, as illustrated in Fig. 9. In this arithmetic circuit, adders 10 are changed in place with subtractors 11 in the arithmetic circuit illustrated in Fig. 7. Therefore, this arithmetic circuit can generate two-line digital quadrature baseband output signals without causing a gain deviation or a phase deviation between the lines.

Referring now to Fig. 10, description will be made on the operation of a multiport amplifying apparatus which employs digital quadrature baseband 90-degree hybrid circuit 2 of Fig. 9. Illustrated herein is a two-line multiport amplifying apparatus for simplifying the description. The two-line multiport amplifying apparatus comprises one digital quadrature baseband 90-degree hybrid circuit 2 illustrated in Fig. 9, two digital quadrature baseband input type amplifiers 4, and one RF-band 90-degree hybrid 6.

Here, two-line digital quadrature baseband input signals are designated by p1, p2, and two-line output signals of RF-band 90-degree hybrid 6 on the output side are designated by r1, r2. When the 90-degree phase delay is represented in matrix through a replacement with Equation (1) in Fig. 7, and the 90-degree phase advance is represented in matrix through a replacement with Equation (4) in Fig. 9, the input/output characteristic of the two-line multiport amplifying apparatus is expressed by Equation (6). In comparison with Equation (3) in Fig. 8 shown in the first embodiment, the two-line multiport amplifying apparatus is characterized in that the upper and lower lines do not invert at the input ports and output ports in the figure. This exemplary modification is similar to the first embodiment in that unlike prior art RF-band 90-degree hybrid 6, each input signal does not have the amplitude $1/\sqrt{2}$ times as much (1/2 times in power), so that the gain of the amplifier can be reduced to $1/\sqrt{2}$ times (1/2 times in power) assuming that the same gain is required to the multiport amplifying apparatus as the prior art.

It should also be apparent that through a similar analysis to the foregoing, the present invention can be applied as well to multiport amplifying apparatuses having any arbitrary number of lines $2^n$ (**n** is a natural number) including four lines and eight lines.

The multiport amplifying apparatus of the first embodiment can limit deviations among lines and improve characteristics such as the combination loss, inter-line isolation, and the like, since digital quadrature baseband signals are processed by the hybrids which make up the input hybrid network.

Also, since the multiport amplifying apparatus of the first embodiment is stable in characteristics with less frequency deviation, temperature induced variations, and aging changes since digital signals are processed in the input hybrid network.

Further, since the multiport amplifying apparatus of the first embodiment can eliminate the gain deviation and phase deviation among lines in the input hybrid network, gain deviation and phase deviation values among the lines required to the overall multiport amplifying apparatus can be distributed to the amplifiers and output hybrid network, thereby facilitating optimal designing for the multiport amplifying apparatus.

Further, according to the first embodiment, since digital signals are processed in the input hybrid network, an adjusting step can be reduced, as would otherwise be required for adjusting cables or microstrip lines or strip lines for each apparatus, the multiport amplifying apparatus can contribute to an improvement in productivity.

Second Embodiment

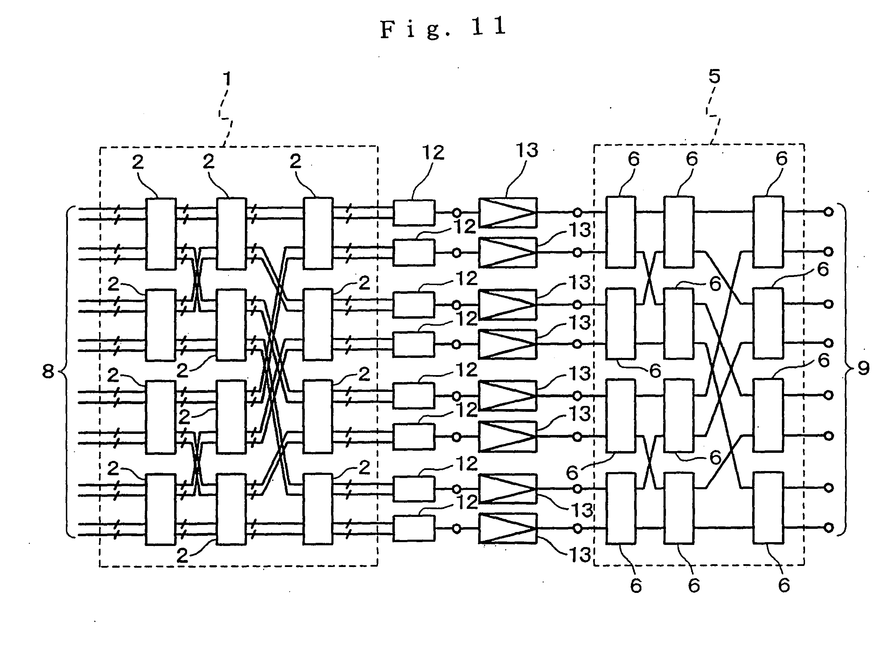

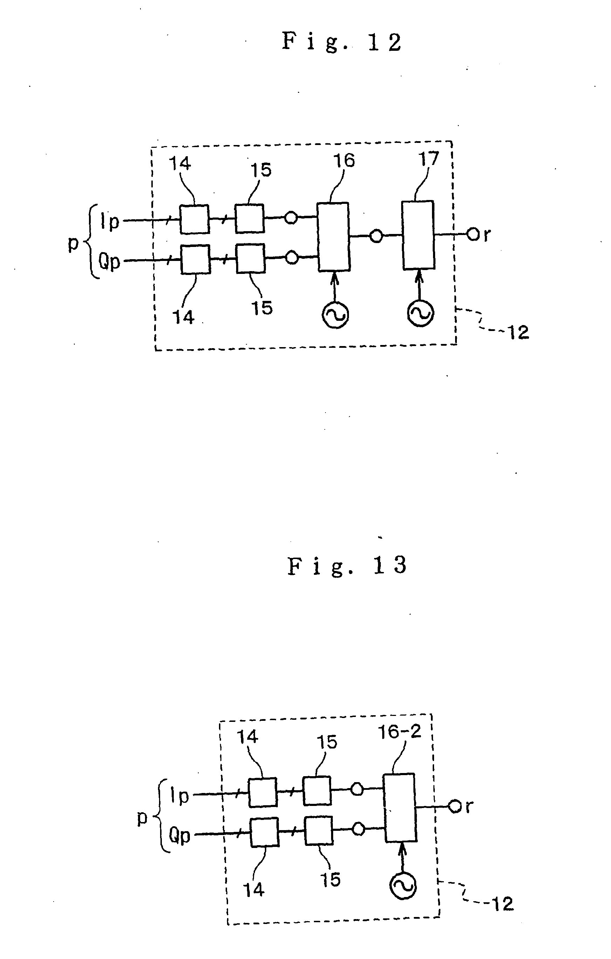

Next, a second embodiment of the present invention will be described with reference to Figs. 11 and 12. Fig. 11 is a block diagram illustrating an exemplary implementation of eight-line multiport amplifying apparatus. The multiport amplifying apparatus of the second embodiment differs from the first embodiment (Fig. 6) in that converter circuits 12 are provided between the output of input digital quadrature baseband hybrid network 1 and amplifiers 13 which are analog RF input amplifiers instead of digital quadrature baseband input amplifiers 4.

Fig. 12 is a block diagram illustrating the basic configuration of converter circuit 12 in Fig. 11. Converter circuit 12 comprises digital-to-analog converters 14, filters 15, analog quadrature modulator 16, and frequency converter circuit 17. There are two each of digital-to-analog converters 14 and filters 15, corresponding to I- and Q-signal components of a received digital quadrature baseband signal, respectively.

Each of digital-to-analog converters 14 converts the I- or Q-signal component of an incoming digital quadrature baseband signal from a digital form to an analog form. Each of filters 15 filters out an aliasing component due to sampling from the analog quadrature baseband signal delivered from digital-to-analog converter 14. Analog quadrature modulator 16 orthogonally modulates the analog quadrature baseband signal, from which the aliasing component has been removed, to generate an IF-band signal. Frequency converter circuit 17 converts the IF-band signal delivered from analog quadrature modulator 16 to an RF-band signal.

Fig. 13 is a block diagram illustrating the basic configuration of converter circuit 12 which is an exemplary modification to converter circuit 12 in Fig. 12 of the second embodiment. Converter circuit 12 in Fig. 13 differs from converter circuit 12 in Fig. 12 in that analog quadrature modulator 16-2 has a function of directly modulating a baseband signal to an RF-band signal. In other words, analog quadrature modulator 16-2 functionally contains analog quadrature modulator 16 and frequency converter circuit 17 in Fig. 12.

Converter circuit 12 comprises digital-to-analog converters 14, filters 15, and analog quadrature modulator 16-2. There are two each of digital-to-analog converters 14 and filters 15, corresponding to I- and Q-signal components of a received digital quadrature baseband signal, respectively.

Each of digital-to-analog converters 14 converts an I- or Q-signal component of an incoming digital quadrature baseband signal from a digital form to an analog form. Each of filters 15 filters out an aliasing component due to sampling from the analog quadrature baseband signal delivered from digital-to-analog converter 14. Analog quadrature modulator 16-2 orthogonally modulates the analog quadrature baseband signal, from which the aliasing component has been removed, to generate an RF-band signal.

As shown above, since converter circuit 12 illustrated in Fig. 12 or 13 is provided at the output of input digital quadrature baseband hybrid network 1, input digital quadrature baseband hybrid network 1 can be applied as well to the multiport amplifying apparatus which employs analog RF input amplifiers 13 as illustrated in Fig. 11, as well as to the multiport amplifying apparatus which employs digital quadrature baseband input amplifiers 4 shown in Fig. 6. Input digital quadrature baseband hybrid network 1 is also applied when analog RF input type amplifiers 13 are implemented by straight type amplifiers which do not compensate for distortion, analog predistortion type amplifiers, feedforward type amplifiers, and the like.

Third Embodiment

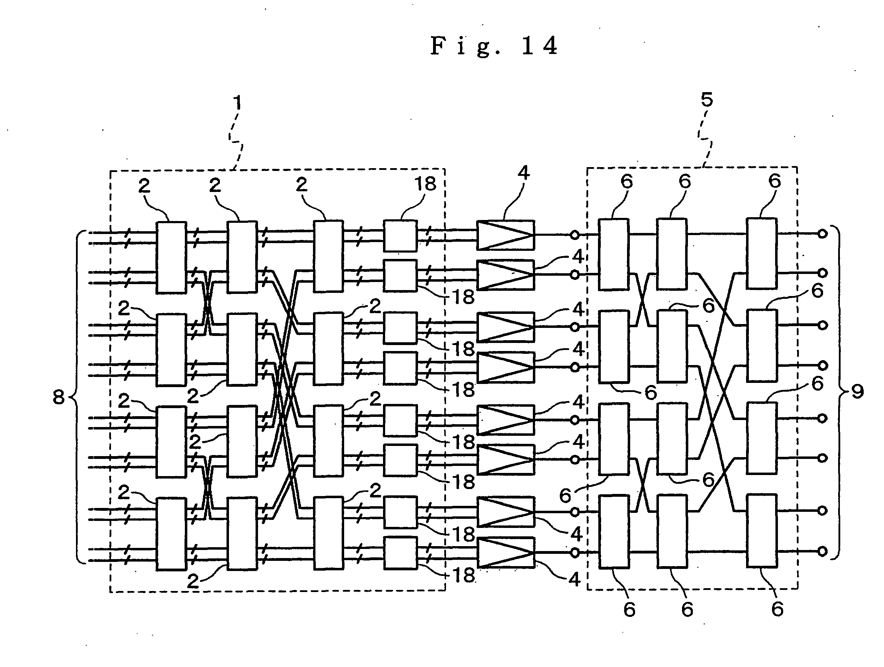

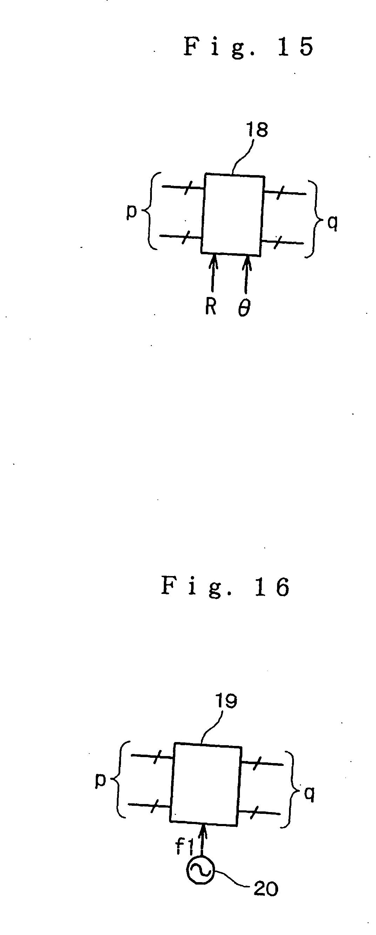

Next, a third embodiment of the present invention will be described with reference to Figs. 14 and 15. Fig. 14 is a block diagram illustrating an exemplary implementation of an eight-line multiport amplifying apparatus. The multiport amplifying apparatus illustrated in Fig. 14 differs from the first embodiment illustrated in Fig. 6 in that input digital quadrature baseband hybrid network 1 contains complex multipliers 18.

Each of complex multipliers 18 is applied with a digital quadrature baseband output signal from digital quadrature baseband 90-degree hybrid circuit 2 at the final stage of input digital quadrature baseband hybrid network 1, and generates a digital quadrature baseband output signal which has been adjusted for amplitude and phase. The digital quadrature baseband output signal delivered from complex multiplier 18 is amplified by associated digital quadrature baseband input type amplifier 4.

As illustrated in Fig. 15, complex multiplier 18 receives digital quadrature baseband signal **p**, amplitude information **R**, and phase information θ , compensates digital quadrature baseband signal **p** for the amplitude (gain) and phase based on amplitude information **R** and phase information θ from the outside, and delivers resulting digital quadrature baseband signal **q**.

With the provision of complex multiplier 18 for adjusting the amplitude and phase of the digital quadrature baseband signal, adjustments can be further simplified to achieve required gain deviation and phase deviation among respective lines in amplifiers 4 and output RF-band hybrid network 5, with the result that optimal designing is facilitated. Also, since complex multiplier 18 processes signals in a digital quadrature baseband signal domain, complex multiplier 18 can be largely reduced in size and cost and can improve the stability, as compared with a prior art gain and phase compensator circuit which operates in an analog RF-band.

Fourth Embodiment

Next, description will be made on a fourth embodiment of the present invention which is a combination of input digital quadrature baseband hybrid network 1 and a circuit according to a known technique. The multiport amplifying apparatus can be provided with expanded functions by combining input digital quadrature baseband hybrid network 1 with a circuit according to a known technique.

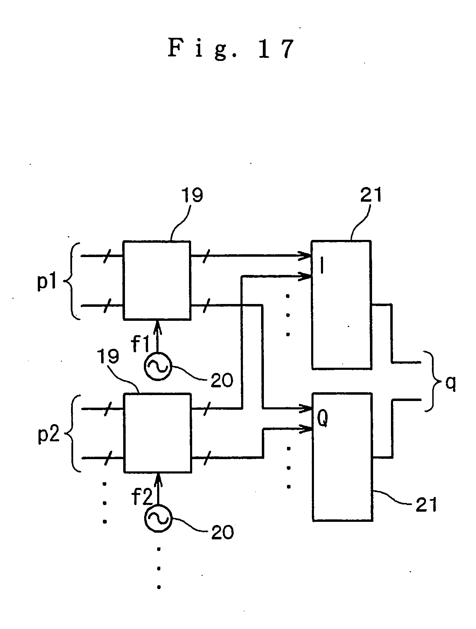

When the multiport amplifying apparatus is applied with signals at different frequencies, frequency converter 19 according to a known technique as illustrated in Fig. 16 may be provided in front of each digital quadrature baseband input port 8 to accommodate the different frequencies. As many frequency converters 19 as the number of lines are provided in front of input digital quadrature baseband hybrid network 1 previously illustrated in Fig. 6, Fig. 11 or Fig. 14. Frequency converter 19 is comprised of a complex multiplier and the like in combination. The frequency of incoming digital quadrature baseband signal **p** is converted with a signal at frequency f1 oscillated by numerically controlled oscillator 20 to generate frequency-converted digital quadrature baseband signal **q**. By appropriately setting frequency f1 assigned to each port, the frequency of each incoming digital quadrature baseband signal **p** can be assigned on the baseband. With frequency converter 19, the frequency assignment is set on the baseband for each digital quadrature baseband input port 8 in Fig. 6, Fig. 11 or Fig. 14.

When a signal composed of a plurality of combined waves is applied to each of the ports of the multiport amplifying apparatus, such a signal can be accommodated by a baseband signal combiner circuit as illustrated in Fig. 17. The baseband signal combiner circuit comprises frequency converters 19 each including a complex multiplier and the like; numerically controlled oscillator 20 for oscillating a signal at specified frequency f; and a baseband combiner 21 comprised of an adder and the like.

Frequency converter 19 and numerically controlled oscillator 20 are arranged at the same number of signals applied to one of the input ports of the multiport amplifying apparatus, and sets the frequency assignment on the baseband. Incoming baseband input signals p1, p2, ... are converted by associated frequency converters 19 to have frequencies f1, f2, ..., respectively. The respective frequency-converted baseband input signals have their I-signal components and Q-signal components combined by associated baseband combiners 21 on the baseband to generate output signal **q**.

A number of baseband signal combiner circuits as illustrated in Fig. 17 equal to the number of lines may be provided in front of input digital quadrature baseband hybrid network 1 illustrated in Fig. 6, Fig. 11 or Fig. 14 to amplify a signal composed of a plurality of combined waves.

While the foregoing description has been made on the application of the present invention to the multiport amplifying apparatus which can be utilized in a multibeam communication satellite and a mobile communication base station using an array antenna, the present invention is not limited to such a particular multiport amplifying apparatus, but digital quadrature baseband 90-degree hybrid circuit 2 illustrated in Figs. 7 and 9 in the foregoing embodiments can be used as a 90-degree hybrid in any configuration other than the multiport amplifying apparatus.

The multiport amplifying apparatus according to the present invention employs the complex multipliers for adjusting the amplitude and phase of a digital quadrature baseband signal to meet required gain deviation and phase deviation among lines distributed to the amplifiers and output hybrid network, so that the multiport amplifying apparatus can contribute to a reduced adjustment step and an improved productivity.

Further, according to the foregoing embodiments, since the input hybrid network and the complex multiplier for adjusting the amplitude and phase of a digital quadrature baseband signal process in a digital quadrature baseband signal domain, the resulting multiport amplifying apparatus can be largely reduced in size and cost, as compared with a conventional counterpart which processes signals in an analog RF-band signal domain. With the reduction in size, the multiport amplifying apparatus can provide an improved versatility for installation thereof. Particularly, in a mobile communication base station using an array antenna, the installation can be facilitated in implementing a tower top apparatus which is structured for mounting on an antenna tower.

While preferred embodiments of the present invention have been described using specific terms, such description is for illustrative purpose only, and it is to be understood that changes and variations may be made without departing from the spirit or scope of the following claims.

**Claims**

1. A multiport amplifying apparatus comprising:

    an input hybrid network having a plurality of input ports;
    a plurality of amplifiers connected to the output of said input hybrid network; and
    an output hybrid network connected to the outputs of said amplifiers and having a plurality of output ports,

    wherein said input hybrid network receives digital quadrature baseband signals from said plurality of input ports, and evenly distributes the input digital quadrature baseband signals to said plurality of amplifiers.

2. The multiport amplifying apparatus according to claim 1, wherein:

    said input hybrid network comprises:

        $2^n$ of said input ports; and
        $2^{(n-1)} \times n$ hybrid circuits,

    wherein each of said hybrid circuits is a digital hybrid circuit for processing a digital quadrature baseband signal.

3. The multiport amplifying apparatus according to claim 2, wherein said digital hybrid circuit is a digital quadrature baseband hybrid circuit comprising:

    an adder for adding incoming digital quadrature baseband signals; and
    a subtractor for subtracting one digital quadrature baseband signal from another.

4. The apparatus according to claim 1,2, or 3, wherein:

    said output hybrid network comprises:

        $2^n$ of said output ports; and
        $2^{(n-1)} \times n$ output hybrid circuits,

    wherein each of said output hybrid circuits is an analog hybrid circuit for processing an analog RF-band signal.

5. The apparatus according to claim 1, 2, 3, or 4, wherein:

    each of said amplifiers is a digital quadrature baseband signal input type amplifier for amplifying a digital quadrature baseband signal received from said input hybrid network and delivering an analog RF-band signal.

6. The apparatus according to claim 1, 2, 3, 4, or 5, further comprising a converter circuit disposed behind said input hybrid network for converting a digital quadrature baseband signal to an analog RF-band signal, said converter circuit including:

    a digital-to-analog converter for converting the digital quadrature baseband signal to an analog quadrature baseband signal;
    a filter for filtering out an aliasing component produced by sampling, said aliasing component being included in said analog quadrature baseband signal; and
    a quadrature modulator for orthogonally modulating the analog quadrature baseband signal from which the aliasing component has been removed,

    wherein each of said amplifiers is an analog RF input type amplifier for amplifying the analog RF-band signal delivered from said converter circuit.

7. The apparatus according to any one of claims 1 to 6, wherein said input hybrid network further comprises:

    a complex multiplier for adjusting the amplitude and phase of the digital quadrature baseband signal.

8. The apparatus according to any one of claims 1 to 7, further comprising a digital frequency converter disposed in front of said input hybrid network.

9. The apparatus according to any one of claims 1 to 8, further comprising a baseband combiner disposed in front of said input hybrid network for combining a plurality of the digital quadrature baseband signals.

# Fig. 1
## PRIOR ART

EP 1 475 887 A2

# F i g . 2

## P R I O R   A R T

$$q1 = p1 \cdot \frac{1}{\sqrt{2}} e^{j0°} + p2 \cdot \frac{1}{\sqrt{2}} e^{-j90°} \quad \cdots (7)$$

$$q2 = p1 \cdot \frac{1}{\sqrt{2}} e^{-j90°} + p2 \cdot \frac{1}{\sqrt{2}} e^{j0°} \quad \cdots (8)$$

$$e^{-j90°} = \cos(-90°) + j\sin(-90°) = -j \quad \cdots (9)$$

$$\begin{pmatrix} r1 \\ r2 \end{pmatrix} = \frac{A}{\sqrt{2}} \begin{pmatrix} 1 & -j \\ -j & 1 \end{pmatrix} \begin{pmatrix} q1 \\ q2 \end{pmatrix}$$

$$= \frac{A}{\sqrt{2}} \cdot \frac{1}{\sqrt{2}} \underbrace{\begin{pmatrix} 1 & -j \\ -j & 1 \end{pmatrix}}_{\substack{\text{output side} \\ \text{matrix}}} \underbrace{\begin{pmatrix} 1 & -j \\ -j & 1 \end{pmatrix}}_{\substack{\text{input side} \\ \text{matrix}}} \begin{pmatrix} p1 \\ p2 \end{pmatrix} = -jA \begin{pmatrix} p2 \\ p1 \end{pmatrix} \quad \cdots (10)$$

Fig. 3
PRIOR ART

Fig. 4
PRIOR ART

Fig. 5
PRIOR ART

EP 1 475 887 A2

Fig. 6

F i g . 7

$$e^{-j90°} = \cos(-90°) + j\sin(-90°) = -j \quad \cdots(1)$$

$$\begin{pmatrix} I' \\ Q' \end{pmatrix} = \begin{pmatrix} 0 & 1 \\ -1 & 0 \end{pmatrix} \begin{pmatrix} I \\ Q \end{pmatrix} = \begin{pmatrix} Q \\ -I \end{pmatrix} \quad \cdots(2)$$

F i g . 8

$$\begin{pmatrix} r1 \\ r2 \end{pmatrix} = \frac{A}{\sqrt{2}} \underbrace{\begin{pmatrix} 1 & -j \\ -j & 1 \end{pmatrix}}_{\substack{\text{output side} \\ \text{matrix}}} \underbrace{\begin{pmatrix} 1 & -j \\ -j & 1 \end{pmatrix}}_{\substack{\text{input side} \\ \text{matrix}}} \begin{pmatrix} p1 \\ p2 \end{pmatrix} = -jA\sqrt{2} \begin{pmatrix} p2 \\ p1 \end{pmatrix} \quad \cdots(3)$$

## F i g. 9

$$e^{j90°} = \cos(90°) + j\sin(90°) = j \quad \cdots(4)$$

$$\begin{pmatrix} I' \\ Q' \end{pmatrix} = \begin{pmatrix} 0 & -1 \\ 1 & 0 \end{pmatrix}\begin{pmatrix} I \\ Q \end{pmatrix} = \begin{pmatrix} -Q \\ I \end{pmatrix} \quad \cdots(5)$$

## F i g. 10

$$\begin{pmatrix} r1 \\ r2 \end{pmatrix} = \frac{A}{\sqrt{2}}\underbrace{\begin{pmatrix} 1 & -j \\ -j & 1 \end{pmatrix}}_{\text{output side matrix}}\underbrace{\begin{pmatrix} 1 & j \\ j & 1 \end{pmatrix}}_{\text{input side matrix}}\begin{pmatrix} p1 \\ p2 \end{pmatrix} = A\sqrt{2}\begin{pmatrix} p1 \\ p2 \end{pmatrix} \quad \cdots(6)$$

Fig. 11

EP 1 475 887 A2

Fig. 12

Fig. 13

# Fig. 14

EP 1 475 887 A2

F i g . 1 5

F i g . 1 6

Fig. 17